(19) Europäisches Patentamt

European Patent Office

Office européen des brevets

(11) Veröffentlichungsnummer: **0 343 273 B1**

(12) **EUROPÄISCHE PATENTSCHRIFT**

(45) Veröffentlichungstag der Patentschrift: **27.04.94**

(21) Anmeldenummer: **88108442.0**

(22) Anmeldetag: **27.05.88**

(51) Int. Cl.5: **H03D 7/16**, H03D 1/22, H03D 3/00

(54) **Korrekturschaltung für ein digitales Quadratur-Signalpaar.**

(43) Veröffentlichungstag der Anmeldung:
**29.11.89 Patentblatt 89/48**

(45) Bekanntmachung des Hinweises auf die
Patenterteilung:
**27.04.94 Patentblatt 94/17**

(84) Benannte Vertragsstaaten:
**DE FR GB IT NL**

(56) Entgegenhaltungen:
**EP-A- 0 048 229**
**EP-A- 0 074 858**
**EP-A- 0 122 657**
**EP-A- 0 180 339**
**EP-A- 0 237 590**

(73) Patentinhaber: **Deutsche ITT Industries GmbH**
**Hans-Bunte-Strasse 19**
**D-79108 Freiburg(DE)**

(72) Erfinder: **Reich, Werner, Dr. Ing.**
**Kleiststrasse 2a**
**D-7830 Emmendingen(DE)**

**Beschreibung**

Die Erfindung betrifft eine Korrekturschaltung für ein digitales Quadratur-Signalpaar, das aus einem Inphase-Signal und einem Quadratur-Signal besteht. Analoge oder digitale Quadratur-Signalpaare finden dort Verwendung, wo mittels eines einzigen Trägers gleichzeitig zwei Signale übertragen werden sollen, beispielsweise bei den üblichen Farbfernseh-Standards oder bei der digitalen Quadraturamplitudenmodulation, zunehmend aber auch dort, wo Signale in einen anderen Frequenzbereich umgesetzt werden, beispielsweise bei der Tief-Zwischenfrequenzumsetzung beliebig modulierter Signale, bei einigen Verfahren der Einseitenbandumsetzung oder bei der digitalen Verarbeitung von Radarsignalen. Die Korrekturschaltung nach der Erfindung ist dabei vorteilhaft auf winkelmodulierte Signale anzuwenden.

In allen diesen Fällen ist eine genaue Weiterverarbeitung der beiden Quadratur-Komponenten nur möglich, wenn die jeweiligen Frequenzanteile des analogen oder digitalen Quadratur-Signalpaars genau gleiche Amplituden aufweisen und in der Phase genau um 90° gegeneinander versetzt sind. Beim Tief-Zwischenfrequenzverfahren, bei dem das Quadratur-Signalpaar auf der Empfangsseite durch eine analoge Quadraturmischung gebildet wird, entstehen durch kaum vermeidbare Unsymmetrien in den beiden Signalpfaden derartige Abweichungen, die letzten Endes zu untragbaren Störungen führen.

Abhilfe schaffen hier Korrekturschaltungen, die mittels geeigneter Detektoren Fehler oder Störkomponenten in der jeweiligen Amplitude und der jeweiligen Phase des Quadratur-Signalpaares erkennen und daraus Korrektursignale erzeugen, um die Fehler möglichst zu beseitigen. Eine derartige Korrekturschaltung ist beispielsweise für analoge Quadratur-Signalpaare in EP-A 122 657 (= US-A 46 33 315) für eine Tief-Zwischenfrequenzumsetzung beschrieben, bei der ein hochfrequent übertragenes Fernsehsignal in das Basisband umgesetzt wird.

Der Übergang von einer analogen Signalverarbeitung auf eine digitale ist an und für sich für derartige Quadratur-Signalpaare sehr vorteilhaft, weil ein großer Teil der Unsymmetrien der beiden Signalpfade dabei entfällt, wie z.B. unterschiedliche Einflüsse durch Alterung, Temperatur, Änderung von Abgleicheinstellungen und unterschiedliche interne oder externe Stör- oder Nutzsignalverkopplungen, und in digitaler Technik aufwendige Filter- und Verarbeitungsschaltungen realisierbar sind, die in analoger Technik kaum möglich sind. Allerdings sind die durch die Digitalisierung zu erzielenden Vorteile nur dann zu erreichen, wenn auch die Genauigkeit des digitalen Quadratur-Signalpaares ebenfalls den höheren Anforderungen genügt. Hierzu lassen sich auch aufwendige Korrekturschaltungen in digitaler Technik vorteilhaft realisieren. Z.B. zeigt EP-A 237 590 eine derartige digitale Korrekturschaltung zur Phasen- und Amplitudenkorrektur. Die jeweiligen Korrektursignale werden mittels Addier-bzw. Subtrahierschaltungen der jeweiligen Quadratur-Komponente hinzuaddiert bzw. von ihr abgezogen. Dabei ist das jeweilige Korrektursignal durch Produktbildung aus einer der Quadratur-Komponenten mit dem zugehörigen Korrekturfaktor gebildet, der mittels einer Regelschaltung aus dem zugehörigen Fehlersignal erzeugt wird.

In der Bildung der Fehlersignale liegt die eigentliche Schwierigkeit für jede Korrekturschaltung. Die Feststellung einer vorhandenen Abweichung ist noch verhältnismäßig einfach, wenn wie beim Farb-Bild-Austast-Synchron-Signalgemisch, dem FBAS-Signal, während jeder Bildzeile der eigentliche Hochfrequenzträger, der auch als Bildträger dient, mit definierter Amplitude während des Zeilen-Synchronimpulses übertragen wird und ebenfalls in jeder Bildzeile für das Burst-Signal der Hochfrequenzträger mit dem reinen Farbhilfsträger moduliert wird, der während dieser Zeit mit definierter Amplitude und definierter Phase genau festgelegt ist. Das durch das Burst-Signal festgelegte Quadratur-Signalpaar stellt dabei gleichsam einen mit konstanter Frequenz umlaufenden Zeiger konstanter Länge dar.

Die Bildträgerschwingung während des Synchronimpulses und/oder die Farbhilfsträgerschwingung während des Burst-Signals können somit als Referenz bei der Tief-Zwischenfrequenzumsetzung bzw. bei der Farb-Signalverarbeitung dienen. Bei der Tief-Zwischenfrequenzumsetzung kann z.B. die Bildung des Phasenfehlers durch Produktbildung aus dem Inphase- und dem Quadratur-Signal und die Bildung des Amplitudenfehlers aus dem Vergleich (= Differenzbildung) der mittleren Amplitudenquadratwerte des Inphase- und des Quadratur-Signals erfolgen.

Diese Art der Fehlersignalbildung ist jedoch bei bei der Tief-Zwischenfrequenzumsetzung von Signalen ohne reine Träger- oder Hilfsträger-Übertragung nicht möglich, weil der durch das Quadratur-Signalpaar gebildete resultierende Zeiger ständig moduliert ist und zu keiner Zeit eine definierte Bezugsgröße enthält.

Eine Korrekturschaltung für digitale Quadratur-Signalpaare, die bei der Tief-ZF-Frequenzumsetzung eines Rundfunksignals mit amplituden- oder frequenzmoduliertem Träger entstehen, ist in EP-A 0 180 339 beschrieben. Die Schaltung enthält Korrektureinrichtungen für eine digitale Offset-, Phasen- und Amplitudenkorrektur des Quadratur-Signalpaares. Mittels Hilfsschaltungen, die mit dem Signalpfad des digitalen Quadratur-Signalpaars gekoppelt sind, werden die erforderlichen Offset-, Phasen- und Amplitudenstellsignale erzeugt. Die Korrekturen erfolgen teilweise über Rückkopplungsschleifen, teilweise über Kompensations- oder Steuerschaltungen ohne Rückkopplungsschleifen. Bei dem beschriebenen Verfahren handelt es sich jedoch lediglich um eine einfache AM- oder FM-Modulation eines Trägers. Ein Stereo-Multiplex-Signal für eine Stereo-Wiedergabe mit Summen und Differenzsignal wird in EP-A 0 180 339 nicht angesprochen.

Es ist daher Aufgabe der durch die Patentansprüche gekennzeichneten Erfindung, eine Korrekturschaltung für digitale Quadratur-Signalpaare anzugeben, die eine genaue Korrektur des Inphase- und des Quadratur-Signals ermöglicht, auch wenn im ursprünglichen Signal oder im Quadratur-Signalpaar ein unmodulierter Träger oder ein leicht detektierbarer Hilfsträger nicht vorhanden ist.

Die Erfindung wird nun anhand der Figuren der Zeichnung näher erläutert:

Fig. 1 zeigt in Form eines Blockschaltbildes schematisch eine bekannte Tief-Zwischenfrequenzumsetzungs-Schaltung,

Fig. 2 zeigt in analoger Darstellung anhand eines fehlerbehafteten cosinus/sinusförmigen Quadratur-Signalpaares die grundsätzlich auftretenden Fehler sowie das zugehörige korrigierte Quadratur-Signalpaar,

Fig. 3 zeigt als Blockschaltbild ein Ausführungsbeispiel für die Stelleinrichtungen im Inphase- und Quadratur-Signalpfad,

Fig. 4 zeigt in analoger Darstellung, wie sich die in Fig. 2 dargestellten Quadratur-Signalfehler auf den resultierenden Zeiger auswirken,

Fig. 5 zeigt das Blockschaltbild eines Ausführungsbeispiels der Werte-Erfassungs- und der Fehler-Erkennungsstufe,

Fig. 6 zeigt das Blockschaltbild eines Ausführungsbeispiels des Maximum-Detektors,

Fig. 7 zeigt als Blockschaltbild ein Ausführungsbeispiel der Korrekturschaltung nach der Erfindung, und

Fig. 8 zeigt als Blockschaltbild das Ausführungsbeispiel eines nichtlinearen Reglers.

Der Erfindung liegt die Erkenntnis zugrunde, daß das der Fehlersignalbildung zugeführte fehlerbehaftete Quadratur-Signalpaar u, v als umlaufender resultierender Zeiger in polarer Darstellung angesehen werden kann, der bei ausreichend hoher Umlauffrequenz als Ortskurve eine Ellipse beschreibt, deren Lage und deren Achsenverhältnis von den Fehlern des Quadratur-Signalpaares u, v bestimmt ist. Ohne diese Fehler ergäbe sich ein exakter Kreis um den Koordinatenursprung. Durch die Bestimmung charakteristischer Ortskurvenfehler, indem die Abweichung der tatsächlichen elliptischen Ortskurve von einem idealen im Koordinatenursprung zentrierten Kreis festgestellt wird, lassen sich die erforderlichen Fehler-Signale finden, die über, einen zugehörigen Regler geführt, die jeweiligen Stelleinrichtungen des Inphase- und des Quadratur-Signalpfades U, V speisen.

Die jeweiligen Fehler könnten auch durch nicht rückgekoppelte Systeme kompensiert werden. Eine Reglerstruktur hat aber den Vorteil, daß einfachere, z. B. auch nichtlineare Systeme, verwendet werden können. Die Regler enthalten im allgemeinen ein Tiefpaßfilter oder einen Integrator, um niedere Frequenzen und Gleichanteile als Regelsignale durchzulassen, höhere Frequenzen dagegen, die als kurzzeitige oder ständig wirkende Störgrößen angesehen werden, zu unterdrücken.

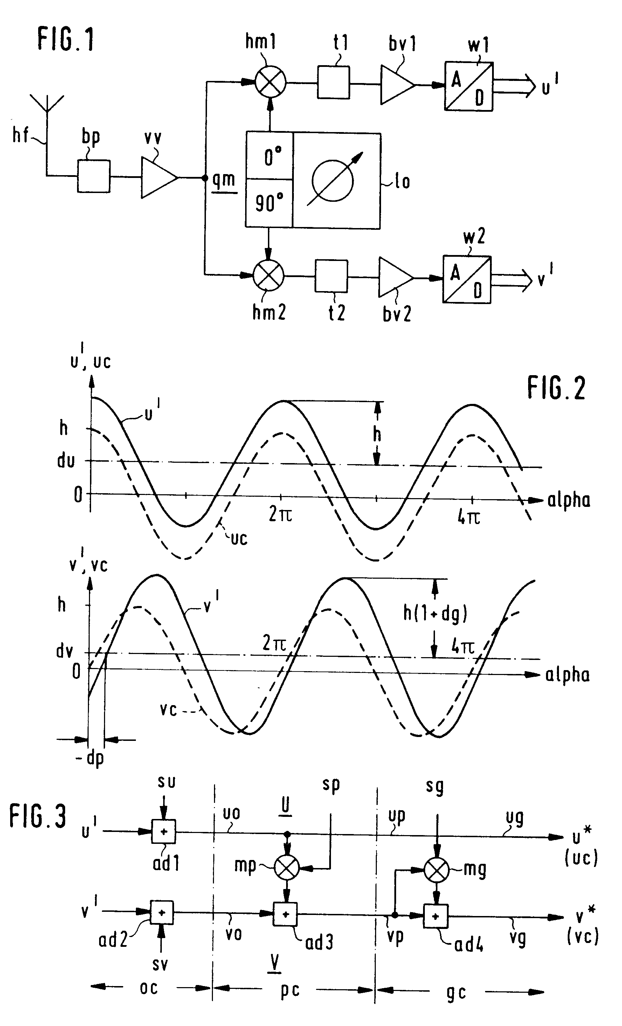

Die in Fig. 1 schematisch dargestellte Tief-Zwischenfrequenzumsetzungs-Schaltung enthält den Quadraturmischer qm, der das von der Antenne kommende Hochfrequenz-Signal hf direkt in das Basisband als analoges Quadratur-Signalpaar umsetzt, wobei das digitale Inphase-Signal (= u-Signal) u' bzw. das digitale Quadratur-Signal (= v-Signal) v' mittels des ersten bzw. des zweiten A/D-Umsetzers w1, w2 gebildet ist und ein nicht gezeigter Systemtakt wie üblich die Digitalisierung steuert. Das der Antenne entstammende Hochfrequenz-Signal hf ist mittels des Hochfrequenzbandpasses bp grob vorselektiert und mittels des Vorverstärkers vv auf eine ausreichende Amplitude gebracht, um mittels des Quadraturmischers qm möglichst verzerrungsfrei in das Basisband umgesetzt zu werden.

Der Quadraturmischer qm enthält den ersten und den zweiten Hochfrequenzmischer (hm1, hm2), dessen Signaleingang jeweils am Ausgang des Vorverstärkers vv liegt. Der jeweilige Trägereingang der beiden Hochfrequenzmischer ist mit dem 0°- bzw. mit dem 90°-Signalausgang des lokalen Oszillators lo verbunden. Der zulässige Oberwellenanteil des lokalen Oszillators lo ist dabei von der Güte der Vorselektion im Hochfrequenzbandpaß bp abhängig, damit keine Mischungssignale aus unerwünschten Kanälen in das Nutzsignal des Basisbandes gelangen. Ähnliches gilt für die Linearität der Hochfrequenzmischer hm1, hm2, die ebenfalls so gut sein muß, daß im Nutzband keine mischungsbedingten Störfrequenzen auftreten. Das Ausgangssignal der beiden Hochfrequenzmischer ist über den jeweiligen Tiefpaß t1, t2 und den jeweiligen Basisband-Verstärker bv1, bv2 geführt, wobei deren Ausgangssignale das analoge u- bzw. das analoge v-Signal sind.

Bei der Tief-Zwischenfrequenzumsetzung liegt im allgemeinen die Frequenz des lokalen Oszillators lo im Frequenzbereich des hochfrequenten Kanals. Die erfindungsgemäße Korrekturschaltung erfordert, daß die Frequenz des lokalen Oszillators lo bei der Quadraturmischung so neben der Frequenz des hochfrequenten Trägers liegen muß, daß die Frequenz des heruntergemischten Trägers bei Audiosignalen beispielsweise 10 kHz beträgt. Dieser Wert ist bei FM-Stereo-Signalen vorteilhaft, weil eventuell verbleibende Restfehler in Verstärkung und Phase nach der Demodulation zu Störsignalen bei 20 kHz führen, die dann weder im Summen- noch im Stereo-Differenz-Signal liegen.

Fig. 2 zeigt in analoger Darstellung als Funktion des Phasenwinkels alpha das unkorrigierte u- und das unkorrigierte v-Signal u′, v′ und als gestrichelte Linie das zugehörige korrigierte u- und das korrigierte v-Signal uc, vc. In der Darstellung ist dabei davon ausgegangen, daß die absolute Amplitude und die absolute Phase des unkorrigierten Quadratur-Signalpaares u′, v′ nicht von Bedeutung ist. Daher kann der Phasen- und der Amplitudenfehler auf das unkorrigierte u-Signal u′ bezogen werden, das damit als Referenz-Signal angesehen wird. Verstärkungs- und Phasenfehler treten dann nur beim unkorrigierten v-Signal v′ auf.

Diese vereinfachende, jedoch voll gültige Betrachtungsweise, wird für die weitere Beschreibung beibehalten. Selbstverständlich wäre auch eine Betrachtungsweise gültig, bei der das unkorrigierte v-Signal v′ als Referenz angesehen würde und die Amplituden- und die Phasenkorrektur dann nur das unkorrigierte u-Signal u′ beträfen. Bei einer kohärenten Modulation schließlich kann sowohl das unkorrigierte u-als auch das unkorrigierte v-Signal jeweils einen Phasen- und/oder Verstärkungsfehler aufweisen. Dann muß mittels der Korrekturschaltung sowohl das unkorrigierte u- als auch das unkorrigierte v-Signal u′, v′ in der Phase und in der Amplitude korrigiert werden.

Die in Fig. 2 gezeigten Fehler sind beim unkorrigierten u-Signal u′ der Inphase-Offsetfehler du, beim unkorrigierten v-Signal v′ der Quadratur-Offsetfehler dv, der Phasenfehler dp sowie der Amplitudenfehler dg, dessen Ursache eigentlich ein Verstärkungsfehler ist. Dabei ist mit h die Sollamplitude des u- und des v-Signals bezeichnet, die bei der Tief-Zwischenfrequenzumsetzung proportional zur Amplitude des Hochfrequenzträgers ist. Das dargestellte unkorrigierte v-Signal v′ mit dem Amplitudenfehler dg hat also als Amplitude den Wert h(1 + dg).

Der Amplitudenfehler dg hat seine Ursache in unterschiedlichen Pegeln der beiden Ausgangssignale des lokalen Oszillators lo und in unterschiedlichen Verstärkungen der beiden Hochfrequenzmischer hm1, hm2, der beiden Tiefpässe t1, t2, der beiden Basisband-Verstärker bv1, bv2 und der beiden A/D-Umsetzer w1, w2. Der gesamte Verstärkungsfehler kann somit leicht eine Amplitudenabweichung von 10% bewirken.

Der Phasenfehler dp hat seine Hauptursache in der nicht exakten 90°-Phasenlage der beiden Mischersignale des lokalen Oszillators lo.

Die Offsetfehler du, dv sind durch die A/D-Umsetzer und die gleichspannungsgekoppelten Stufen vor der Digitalisierung verursacht. Aber selbst bei der Verwendung wechselspannungsgekoppelter Stufen sind offsetähnliche Fehler zu beachten. Ein Wechselspannungsverstärker mit sehr niedriger Grenzfrequenz kann als ein Gleichspannungsverstärker angesehen werden, von dessen Ausgangssignal die vom Wechselspannungsverstärker unterdrückten, im Signal aber vorhandenen niederfrequenten Komponenten subtrahiert werden. Dies entspricht der Addition einer signalabhängigen, langsam zeitveränderlichen Offsetspannung. Somit wirken sich die wegen der hohen Verstärkung erforderlichen Wechselspannungsverstärker ebenfalls auf den Offsetfehler du, dv aus.

In Fig. 2 ist der Phasenfehler -dp als derjenige Wert dargestellt, um den das unkorrigierte v-Signal v′ gegenüber dem korrigierten v-Signal vc nacheilt. Da das unkorrigierte u- und das korrigierte u-Signal u′, uc als cosinusförmige Signale dargestellt sind, ist das korrigierte v-Signal vc sinusförmig.

Im Gegensatz zu Systemen, die bereits demodulierte Signale verarbeiten, wirken sich bei der Tief-Zwischenfrequenzumsetzung von winkelmodulierten Signalen alle hier genannten Fehler so aus, daß sich im allgemeinsten Fall nichtlineare Verzerrungen des demodulierten Signals ergeben - auch bei Offsetfehlern. Durch geeignete Wahl der Frequenz des lokalen Oszillators lo kann ein konstantes Störsignal in einen nicht mehr störenden Bereich außerhalb des Nutzsignals verlagert werden. Verzerrungen bei der Übertragung eines Nutzsignals werden indessen nicht reduziert. Eine Abhilfe ist daher nur durch Korrektur des fehlerhaften Quadratur-Signalpaares u′, v′ möglich.

Die eigentliche Messung der Fehler sollte bei digitalisierten Anordnungen immer nach den A/D-Umsetzern erfolgen, um deren Fehler bei der Korrektur mitzuerfassen, die entweder analog vor oder digital nach den A/D-Umsetzern ausgeführt werden kann. Ein analoges Stellen würde aber eine D/A-Umsetzung der jeweiligen Stell- oder Regelsignale erfordern; dies wird beim digitalen Stellsystem vermieden. Die weitere Betrachtung bezieht sich somit auf digitale Stelleinrichtungen, die insbesondere durch Addierschaltungen und Multiplizierer realisiert sind. Vorteilhaft ist dabei die Anwendung des Zweierkomplement-Codes für die zugeführten Daten oder Signale.

Das in Fig. 2 dargestellte unkorrigierte Quadratur-Signalpaar u′, v′ läßt sich durch folgende Gleichungen (1) und (2) beschreiben:

$$u′ = h\cos\alpha + du \qquad (1)$$

v' = (1+dg)hsin(alpha + dp) + dv     (2)

Dabei ist:

"alpha" die zeitabhängige Phase, die bei FM-Signalen die eigentliche Modulation enthält,

"h>O" wie beschrieben die Sollamplitude des u- und des v-Signals, und

"du, dv, dp und dg" sind die bereits oben genannten Quadratur-Signalfehler.

Fig. 3 zeigt schematisch ideale Stelleinrichtungen, die bei der Zuführung geeigneter Stellsignale alle Quadratur-Signalfehler vollständig beseitigen können. Das am Ausgang der idealen Stelleinrichtungen abgreifbare Ausgangs-Quadratur-Signalpaar u*, v* ist dann das gewünschte voll korrigierte Quadratur-Signalpaar uc, vc.

Um die in Fig. 1 dargestellten Quadratur-Signalfehler vollständig zu beseitigen, sind folgende ideal wirkende Stellsignale erforderlich, die aus den Gleichungen (1) und (2) ableitbar sind:

- das Inphase-Offset-Stellsignal, das u-Stellsignal, su = -du,
- das Quadratur-Offset-Stellsignal, das v-Stellsignal, sv = -dv,
- das Phasen-Stellsignal sp = -(1+dg) sin dp, und
- das Ampliduen-Stellsignal sg = -1 + 1/(1+dg)•cosdp.

Übliche Verfahren zur Korrektur des Quadratur-Signalpaares u', v' verwenden z.B.:

- den Gleichanteil des unkorrigierten u-Signals u' zur Korrektur des Inphase-Offsetfehlers du,
- den Gleichanteil des unkorrigierten v-Signals v' zur Korrektur des Quadratur-Offsetfehlers dv,
- den Gleichanteil des aus dem unkorrigierten Quadratur-Signalpaar gebildeten Produkts u', v' zur Korrektur des Phasenfehlers dp und schließlich
- den Gleichanteil des aus dem unkorrigierten Quadratursignalpaar u', v' gebildeten Therms $u'^2$-$v'^2$ bzw.|u'|-|v'|zur Korrektur des Amplitudenfehlers dg.

Die Gleichanteile dieser Terme bilden in den zugehörigen trigonometrischen Funktionen jeweils einen Summanden, der eine ungerade Funktion des zu korrigierenden Fehlers darstellt und der in einer Regelung das jeweilige Stellsignal su, sv, sp, sg in der richtigen Stellrichtung beeinflußt. Obwohl diese Systeme bei einem unmodulierten Träger erfolgreich sind, kann die Modulation des Trägers in den oben genannten Termen zu zusätzlichen Gleichanteilen führen, die sich den durch die Quadraturfehler bestimmten Gleichanteilen überlagern und zu einer fehlerhaften Funktion der Korrekturschaltung führen, die im ungünstigsten Fall die Quadratur-Signalfehler vergrößert, anstatt sie zu vermindern. Wenn z.B. bei der Tief-Zwischenfrequenzumsetzung aus dem Frequenzspektrum des umzusetzenden Kanals eine Spektrallinie direkt in den Frequenzursprung transformiert wird, dann erscheint diese im Basisband, also auch im unkorrigierten Quadratur-Signalpaar u', v', als Gleichkomponente und wird von der Offset-Korrekturstufe fälschlicherweise wie ein Offsetfehler ausgeregelt.

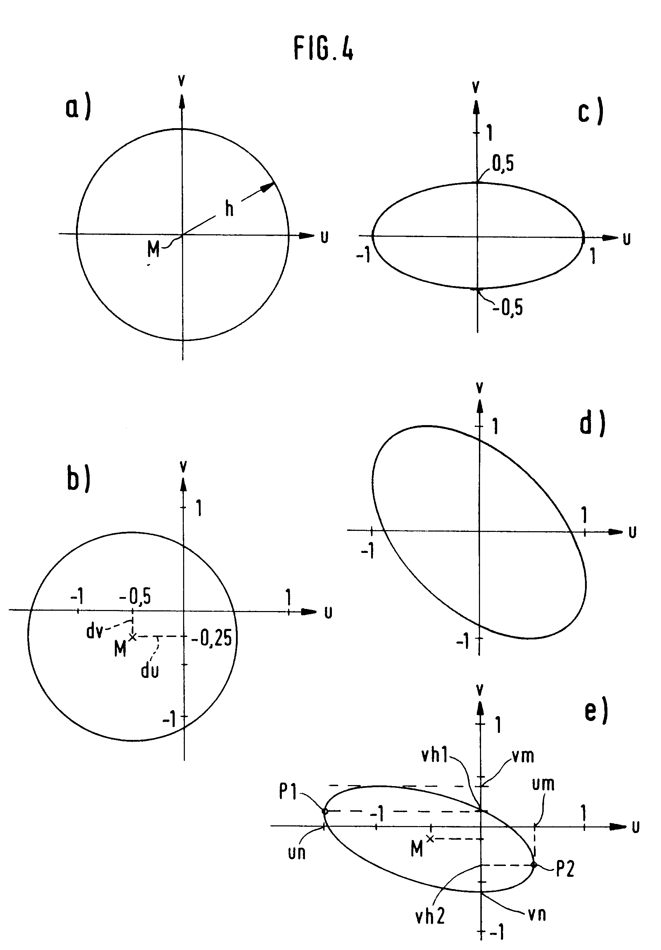

Das der Erfindung zugrundeliegende Korrektursystem verwendet statt der oben genannten Terme geeignet gewählte Werte des Quadratur-Signalpaares, deren wesentlicher Vorteil ist, daß sie von der Winkel-Modulation unabhängig sind. Dies soll im folgenden anhand der Fig. 4 erläutert werden.

Bei der bisherigen Betrachtung wurden die Quadratur-Signalfehler auf das unkorrigierte Quadratur-Signalpaar u', v' bezogen, das direkt am Ausgang des ersten und des zweiten A/D-Umsetzers w1, w2 abgreifbar ist. Die sich daran anschließende Korrekturschaltung enthält einen Inphase- und einen Quadratur-Signalpfad U, V mit verschiedenen Korrekturstufen oc, pc, gc, in deren Verlauf das unkorrigierte Quadratur-Signalpaar u', v'modifiziert wird und am Ausgang als Ausgangs-Quadratur-Signalpaar u*, v* der weiteren Signalverarbeitung zur Verfügung steht. Entsprechend dem Korrekturverhalten kann es sich dabei entweder um das gewünschte korrigierte Quadratur-Signalpaar uc, vc oder ein Quadratur-Signalpaar mit restlichen oder unveränderten Quadratur-Signalfehlern handeln. Die weitere Beschreibung geht daher von der Verallgemeinerung aus, daß das am Quadraturpaar-Signalpfad U, V zur Fehlerermittlung abgegriffene Signal das Quadratur-Signalpaar u, v mit den zugehörigen Quadratur-Signalfehlern ist.

Interpretiert man die beiden Komponenten des Quadratur-Signalpaares u, v als kartesische Koordinaten eines resultierenden Zeigers, so ergibt sich als dessen Ortskurve ohne Quadratur-Signalfehler ein Kreis mit dem Radius h, dessen Mittelpunkt M mit dem Ursprung des Koordinatensystems identisch ist, vgl. Fig. 4a. Offsetfehler du, dv führen zu einer Verschiebung des Mittelpunkts M aus dem Ursprung, die Ortskurve bleibt aber ein Kreis, vgl. Fig. 4b mit h = 1.

Der Amplitudenfehler dg führt zu einer elliptischen Form der Ortskurve, vgl. Fig. 4c, in der die v-Amplitude nur halb so groß wie die auf eins normierte u-Amplitude ist.

Der Phasenfehler dp führt ebenfalls zu einer elliptischen Ortskurve, deren Hauptachsen jedoch gegenüber dem Koordinatenkreuz gedreht sind. Zusätzlich zum Drehwinkel der Hauptachsen wirkt sich der Phasenfehler auch unterschiedlich auf ihre Längen aus, vgl. Fig. 4d.

Sind alle Fehlerarten gleichzeitig vorhanden, so überlagern sich diese Effekte. Alle diese Fehler sind z. B. in Fig. 4e dargestellt, wobei die u-Amplitude h auf den Wert eins normiert ist. Der Mittelpunkt M der gedrehten Ellipse liegt auf den Koordinatenwerten u = -0,5 und v = -0,125. Die Extremwerte bezüglich der beiden Koordinaten u, v sind:

der Inphase-Maximalwert (= u-Maxwert) um,

der Inphase-Minimalwert (= u-Minwert) un,

der Quadratur-Maximalwert (= v-Maxwert) vm und

der Quadratur-Minimalwert (= v-Minwert) vn.

Ferner sind diejenigen Punkte P1 bzw. P2 der Ortskurve eingezeichnet, in denen der u-Minwert un bzw. der u-Maxwert um auftritt. Die zugehörigen v-Werte sind der erste bzw. der zweite Quadratur-Haltewert (= v-Haltewert) vh1, vh2.

Aus diesen speziellen Ortskurvenwerten nach Fig. 4e lassen sich für die beiden Gleichungen (1) und (2) durch Umformung folgende Größen bestimmen:

$$un = -h + du \qquad (3)$$

$$um = h + du \qquad (4)$$

$$vn = -h(1 + dg) + dv \qquad (5)$$

$$vm = h(1 + dg) + dv \qquad (6)$$

$$vh1 = -h(1 + dg)sindp + dv \qquad (7)$$

$$vh2 = h(1 + dg)sindp + dv \qquad (8)$$

Geeignete Kombinationen dieser Gleichungen führen zu folgenden Gleichungen:

$$un + um = 2du \qquad (9)$$

$$vn + vm = 2dv \qquad (10)$$

$$vh2 - vh1 = 2h(1 + dg)sindp \qquad (11)$$

$$vm - vn - (um - un) = 2hdg \qquad (12)$$

(9) bis (12) sind die vier Bestimmungsgleichungen für die vier angegebenen Quadratur-Signalfehler. Sie stellen jeweils eine ungerade Funktion der zu kompensierenden Fehler dar. Diese Terme können deshalb als Signale in einem Regelkreis derartige Stellsignale su, sv, sp, sg erzeugen, daß mit den angegebenen Stelleinrichtungen die Fehler des Quadratur-Signalpaares u, v ausgeregelt werden. Die eigentliche Struktur der Regler ist dabei nicht von primärem Interesse.

Erwähnt sei noch, daß die Ortskurve ausreichend häufig durchlaufen werden muß, um verläßliche Schätzwerte für die charakteristischen Werte der Ortskurve zu erhalten. Dies kann aber durch einen hinreichend hohen Frequenzoffset des lokalen Oszillators lo bezüglich der Trägerfrequenz erzwungen werden. Eine Winkelmodulation hat auf die Lage der Ortskurve keinen Einfluß.

Die mittels der Regler erzeugten Stellsignale speisen die in Fig. 3 dargestellten Stelleinrichtungen. Das Inphase-Offset-Stellsignal (= u-Stellsignal) su bzw. das Quadratur-Offset-Stellsignal (= v-Stellsignal) sv speist in der Offset-Korrekturstufe oc jeweils den einen Eingang der ersten bzw. der zweiten Addierschaltung ad1, ad2, deren jeweiligem anderen Eingang das unkorrigierte u- bzw. das unkorrigierte Signal u', v' zugeführt ist.

Das Phasen-Stellsignal sp speist in Fig. 3 den einen Eingang des ersten Multiplizierers mp, dessen anderer Eingang mit dem Ausgang der ersten Addierschaltung ad1 verbunden ist. Der Ausgang des ersten Multiplizierers mp ist mit dem einen Eingang der dritten Addierschaltung ad3 verbunden, deren anderer Eingang am Ausgang der zweiten Addierschaltung ad2 liegt. Die Phasen-Korrekturstufe pc schließt sich somit in Signalflußrichtung an die Offset-Korrekturstufe oc an.

In Fig. 3 folgt schließlich in Signalflußrichtung die Amplituden-Korrekturstufe gc, die aus dem zweiten Multiplizierer mg und der vierten Addierschaltung ad4 besteht, deren einer Eingang am Ausgang des zweiten Multiplizierers angeschlossen ist. Der andere Eingang der vierten Addierschaltung ad4 und der eine

6

Eingang des zweiten Multiplizierers liegen gemeinsam am Ausgang der dritten Addierschaltung ad3, und der andere Eingang des zweiten Multiplizierers mg ist mit dem Amplituden-Stellsignal sg gespeist. Das offsetkorrigierte u-Signal uo ist in dieser Anordnung unverändert durch die Phasen-und die Amplituden-Korrekturstufe pc, gc hindurchgeschleift.

Bei der in Fig. 3 dargestellten Anordnung sind die Ausgangssignale der Offset-Korrekturstufe oc das offsetkorrigierte u- und das offsetkorrigierte v-Signal uo, vo; die Ausgangssignale der Phasen-Korrekturstufe pc das phasenkorrigierte u- und das phasenkorrigierte v-Signal up, vp, das auch offsetkorrigiert ist, und schließlich sind die Ausgangssignale der Amplituden-Korrekturstufe gc das amplitudenkorrigierte u- und v-Signal ug, vg, das zusätzlich offset- und phasenkorrigiert ist. Die jeweiligen Stelleinrichtungen arbeiten so, daß bei nicht vorhandenem Fehler das jeweilige Stellsignal gleich null ist und daß bei einer zwangsweise durchgeführten Nullstellung des Stellsignals die jeweilige Stelleinrichtung unwirksam wird und das jeweilige Quadratur-Signalpaar unverändert hindurchläßt.

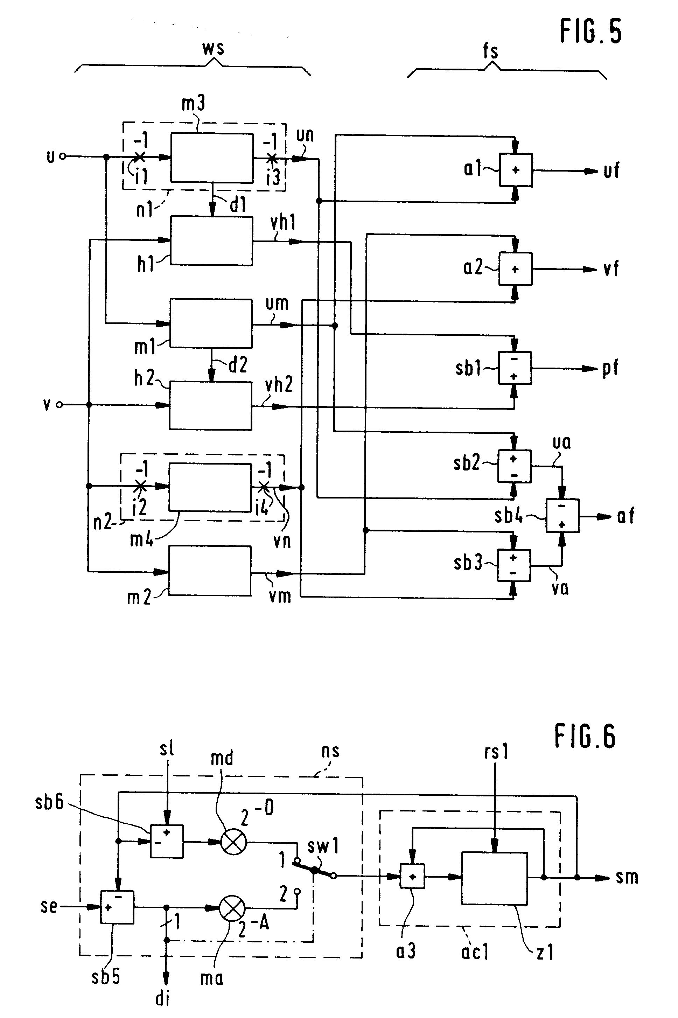

In Fig. 5 ist anhand eines Blockschaltbildes gezeigt, wie die Werte-Erfassungsstufe ws und die Fehler-Erkennungsstufe fs entsprechend den Bestimmungsgleichungen (9) bis (12) die einzelnen Fehlersignale aus den charakteristischen Werten der Ortskurve bilden. Das u-Signal u speist jeweils den Eingang des ersten Minimum- bzw. des ersten Maximum-Detektors n1, m1, deren Ausgangssignal der u-Minwert un bzw. der u-Maxwert um ist.

Das v-Signal v liegt am Eingang der ersten bzw. zweiten Halteschaltung h1, h2, die als Ausgangssignal den ersten bzw. den zweiten v-Haltewert vh1, vh2 bildet und deren jeweiliger Steuereingang vom ersten bzw. zweiten Detektorsignal d1, d2 gesteuert ist, das dem ersten Minimum-Detektor n1 bzw. dem ersten Maximumdetektor m1 entstammt. Ferner ist das v-Signal v dem zweiten Minimum-Detektor n2 bzw. dem zweiten Maximumdetektor m2 zugeführt, die als Ausgangssignal den v-Minwert vn bzw. den v-Maxwert vm bilden.

Der erste bzw. zweite Minimum-Detektor kann als dritter bzw. vierter Maximum-Detektor m3, m4 ausgebildet sein, wenn deren Signaleingang das u- bzw. das v-Signal u, v über den ersten bzw. den zweiten Inverter i1, i2 zugeführt ist und deren Ausgangssignal über den dritten bzw. den vierten Inverter i3, i4 geführt ist. Dabei wird das dem jeweiligen Inverter zugeführte Signal in seinem Wert logisch negiert.

In der Fehler-Erkennungsstufe fs von Fig. 5 wird mittels des ersten Addierers a1 aus dem u-Minwert un und dem u-Maxwert um das Inphase-Offsetfehler-Signal ( = u-Offsetsignal) uf gebildet. Mittels des zweiten Addierers a2 wird aus dem v-Minwert vn und dem v-Maxwert vm das Quadratur-Offsetfehler-Signal ( = v-Offsetsignal) vf gebildet. Mittels des ersten Subtrahiers sb1, dessen Minuend- bzw. Subtrahend-Eingang der zweite bzw. der erste v-Haltewert vh2, vh1 zugeführt ist, wird das Phasenfehler-Signal pf erzeugt.

Mittels des zweiten Subtrahierers sb2, dessen Minuend- bzw. Subtrahend-Eingang der u-Maxwert um bzw. u-Minwert un zugeführt ist, wird der Inphase-Amplitudenwert ( = u-Amplitudenwert) ua erzeugt. Mittels des dritten Subtrahierers sb3, dessen Minuend- bzw. Subtrahend-Eingang der v-Maxwert vm bzw. der v-Minwert vn zugeführt ist, wird der Quadratur-Amplitudenwert ( = v-Amplitudenwert) va erzeugt. Mittels des vierten Subtrahierers sb4, dessen Minuend- bzw. Subtrahend-Eingang mit dem v- bzw. mit dem u-Amplitudenwert va, ua gespeist ist, wird das Amplitudenfehler-Signal af erzeugt.

Die beschriebenen Subtrahierer sind durch Addierer ersetzbar, dabei muß allerdings das dem Subtrahend-Eingang zugeführte Signal mittels eines Inverters in seinem Wert logisch negiert werden.

Das u-Offsetsignal uf entspricht dem Term 2du der Gleichung (9). Das v-Offsetsignal vf entspricht dem Term 2dv der Gleichung (10). Das Phasenfehler-Signal pf entspricht dem Term 2h(1 + dg)sindp der Gleichung (11). Das Amplitudenfehler-Signal af entspricht dem Term 2hdg der Gleichung (12).

Fig. 6 zeigt das schematische Ausführungsbeispiel eines vorteilhaften Maximumdetektors. Das Eingangssignal se speist dabei den Minuend-Eingang des fünften Subtrahierers sb5, dessen Subtrahend-Eingang mit dem Subtrahend-Eingang des sechsten Subtrahierers sb6 und mit dem Ausgang des Maximum-Detektors verbunden ist, der den zu bestimmenden Maximalwert sm abgibt. Der Ausgang des fünften bzw. des sechsten Subtrahierers speist den ersten bzw. den zweiten Festwertmultiplizierer ma, md deren Ausgangssignale dem zweiten bzw. ersten Eingang 2, 1 des elektronischen Umschalters sw1 zugeführt sind.

Der Ausgang des fünften Subtrahierers sb5 bildet auch das Detektorsignal di, das im einfachsten Fall die Vorzeichenstelle des Ausgangssignals ist. Je nach dem Vorzeichen wird mittels des Detektorsignals di die Schaltzunge des ersten elektronischen Umschalters sw1 in die erste oder die zweite Schaltposition 1, 2 gesteuert. Ferner dient das Detektorsignal di der Ansteuerung der ersten oder zweiten Halteschaltung h1, h2.

In Fig. 6 liegen diese Schaltungsteile innerhalb des gestrichelt gezeichneten Blocks, der Nachlaufstufe ns, deren Signal ähnlich wie bei einem analogen Spitzenwertdetektor den Maximalwerten des Eingangssignals se nachläuft. Und zwar wird mittels des ersten bzw. zweiten Festwertmultiplizierers ma, md die Anstiegs- bzw. die Abklingzeit (= attack time bzw. = decay time) bestimmt. Dabei ist dem Minuend-Eingang des sechsten Subtrahierers sb6 ein fester Vorgabewert sl zugeführt, der erforderlich ist, damit bei Maximalwerten im negativen Bereich des Eingangssignals se das langsam abklingende Nachlaufsignal nicht beim Wert null hängen bleibt.

Die beiden Festwertmultiplizierer ma, md bewirken nur eine Stellenverschiebung der zugeführten Signale in Richtung niedriger Werte, also eine Abschwächung um Zweierpotenzen. Im zweiten Festwertmultiplizierer md ist sie wesentlich größer als im ersten Festwertmultiplizierers ma, so daß die Abklingzeit sehr viel größer ist als die Anstiegszeit.

Der Ausgang des ersten elektronischen Umschalters sw1 ist zugleich der Ausgang der Nachlaufstufe ns und speist den Dateneingang des ersten Akkumulators ac1, der aus dem dritten Addierer a3 und dem ersten Verzögerer z1 besteht. Nach einigen Umläufen der Ortskurve baut sich so im Verzögerer z1 als Inhalt der gesuchte Maximalwert sm auf. Mittels des ersten Reset-Signals rs1 kann dieser gelöscht werden, um z.B. einen definierten Startzustand zu erreichen.

Der Vorteil des beschriebenen Maximum-Detektors liegt darin, daß kurzzeitige Störsignale ausgemittelt werden und die Maximalwertbildung nur wenig beeinflussen. Ebenso ist von Vorteil, daß bei einer länger andauernden Störung der richtige Maximalwert sm auch dann wieder gefunden wird, wenn der im Verzögerer z1 gespeicherte Wert zu hoch ist, weil durch den langsam abklingenden Nachlauf der richtige Maximalwert nach einiger Zeit wieder erreicht wird.

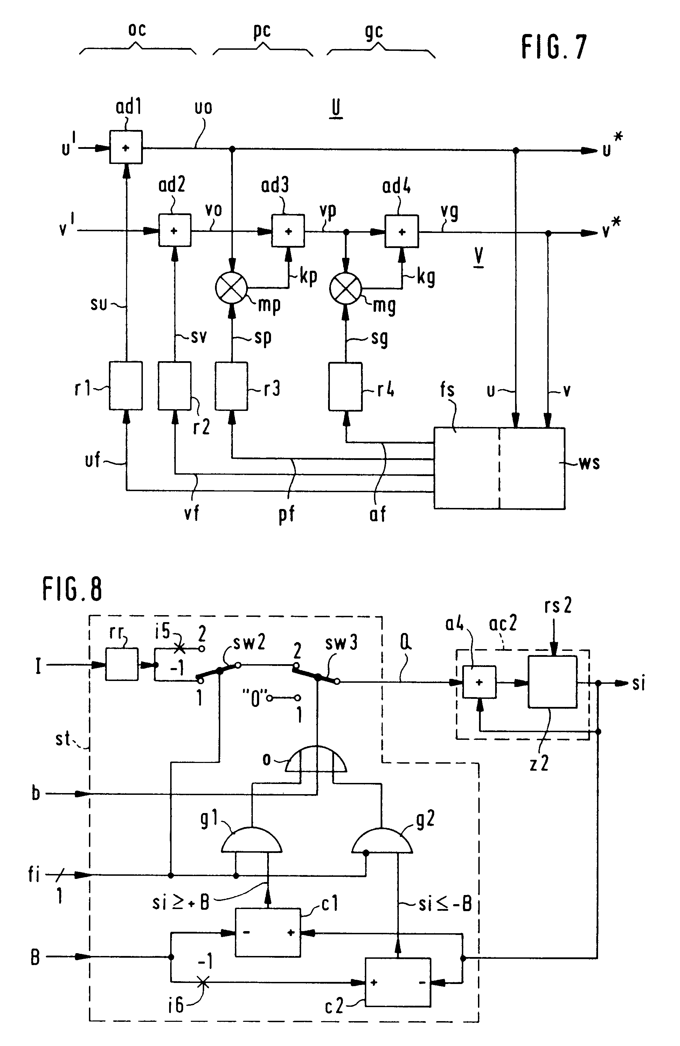

Fig. 7 zeigt schematisch als Blockschaltbild ein Ausführungsbeispiel der vollständigen Korrekturschaltung. Dabei sind die im Inphase- und Quadratur-Signalpfad U, V liegenden Stelleinrichtungen identisch mit denjenigen von Fig. 3. Sie sind dabei Teil einer Regelschaltung, in der das ausgangsseitige Quadratur-Signalpaar u*, v* der Werte-Erfassungsstufe ws als u-und v-Signal u, v zugeführt ist, die daraus mittels der Fehler-Erkennungsstufe fs die zugehörigen Fehlersignale erzeugt. Dabei speist das u- bzw. das v-Offsetsignal uf, vf den ersten bzw. den zweiten Regler r1, r2, dessen Ausgangssignal das u- bzw. das v-Stellsignal su, sv ist; das Phasenfehler-Signal pf speist den dritten Regler r3, dessen Ausgangssignal das Phasen-Stellsignal sp ist, und schließlich speist das Amplitudenfehler-Signal af den vierten Regler r4, dessen Ausgangssignal das Amplituden-Stellsignal sg ist.

Das Ausgangssignal des ersten bzw. des zweiten Multiplizierers mp, mg ist der Phasen- bzw. der Amplitudenkorrekturwert kp, kg, der den einen Eingang der dritten bzw. der vierten Addierschaltung ad3, ad4 speist. Der Phasen- bzw. der Amplitudenkorrekturwert kp, kg und das zugehörige Phasen- bzw. Amplitudenstellsignal sp, sg nehmen den Wert null an, wenn kein Phasen- oder Amplituden-Fehler im Quadratursignalpaar u, v vorhanden sind.

Eine Variante der Amplituden-Korrekturstufe gc kommt ohne die vierte Addierschaltung ad4 aus, wenn statt dessen der zweite Multiplizierer mg direkt in den v-Signalpfad eingefügt wird. Dann wäre ohne Amplitudenfehler der Wert des Amplituden-Stellsignals sg gleich eins.

Fig. 8 zeigt schematisch das Ausführungsbeispiel eines nichtlinearen Reglers, der in der Schaltungsanordnung nach Fig. 7 vorteilhaft zu verwenden ist. Im wesentlichen wird dabei der Inhalt einer Speicheranordnung um den Wert eines Inkrements Q je nach dem Vorzeichen des Fehlersignals fi vergrößert oder verkleinert. Dabei können unterschiedliche Werte des Inkrements Q gewählt werden, indem es mittels des Adreß-Worts I aus dem Inkrement-Speicher rr ausgelesen wird. Damit das von der Speicheranordnung gebildete Stellsignal si innerhalb eines vernünftigen Wertebereichs bleibt, wird es mit dem von außen zugeführten Begrenzungsbereich-Wort B verglichen und bei einer Bereichsüberschreitung in seinem Wert festgehalten. Als Inkrement Q wird am einfachsten eine Zweierpotenz, z.B. $Q = +/- 2^{-16}$, verwendet, die klein bezüglich des im Audiobereich üblicherweise verwendeten Zahlenbereichs von -1 bis +1 ist.

Das Festhalten des Stellsignals si wird auch ferner durch das Blockier-Signal b erreicht, wodurch der Zustand des jeweiligen Reglers "eingefroren" bleibt. Diese Blockierung kann beim Auftreten von Störsignalen sinnvoll sein, um das Weglaufen des Stellsignals si zu verhindern. Andererseits ermöglicht das Blockier-Signal b durch das Einfrieren des Regelzustandes auch eine einfache Inspektion des Reglerverhaltens, weil das Stellsignal si beispielsweise über einen nicht dargestellten Datenbus nach außen geführt werden kann.

In dem schematischen Ausführungsbeispiel nach Fig. 8 ist die Vorzeichenstelle des Fehlersignals fi auf den Steuereingang des zweiten elektronischen Umschalters sw2 geführt, dessen erster Eingang 1 direkt und dessen zweiter Eingang 2 über den fünften Inverter i5 an den Ausgang des Inkrement-Speichers rr angeschlossen sind. Wenn das Fehlersignal fi größer/gleich null ist, liegt die Schaltzunge am Eingang 2 und verkleinert somit das Stellsignal si. Wenn das Fehlersignal fi kleiner als null ist, liegt die Schaltzunge am Eingang 1 und das Stellsignal si wird vergrößert.

Der Ausgang des zweiten elektronischen Umschalters sw2 ist auf den zweiten Eingang 2 des dritten elektronischen Umschalters sw3 geführt, dessen erstem Eingang 1 das Datenwort "O" zugeführt ist. Mittels der beiden elektronischen Umschalter sw2, sw3 kann somit der Inhalt der Speicheranordnung, die z.B. als

EP 0 343 273 B1

zweiter Akkumulator ac2 ausgebildet ist, in seinem Wert verändert werden. Ebenfalls ist das "Einfrieren" des vorhandenen Speicherinhalts möglich. Der zweite Akkumulator ac2 besteht aus dem vierten Addierer a4 und dem mittels des zweiten Reset-Signals rs2 löschbarenzweiten Verzögerer z2. Mit dem zweiten Resetsignal rs2 ist ein definierter Anfangszustand einstellbar.

Die in Fig. 8 als Block gestrichelt dargestellte Steuereinrichtung st enthält ferner eine aus zwei Komparatoren c1, c2 und drei Gattern o, g1, g2 gebildete Logikschaltung, um das Steuersignal für den dritten elektronischen Umschalter sw3 zu bilden. Dieses soll ihn nämlich nur dann in die Position 1 mit der angelegten "O" steuern, wenn das Fehlersignal fi kleiner bzw. größer/gleich null und das Stellsignal si größer/gleich als der positive bzw. kleiner/gleich als der negative Extremwert des zugeführten Begrenzungsbereich-Worts B ist; ein positives Blockier-Signal b soll dagegen immer diese Position 1 erzwingen (vgl. unten die "Funktionstabelle der Steuereinrichtung st").

Das Begrenzungsbereich-Wort B ist dem Subtrahend-Eingang des ersten Komparators c1 direkt und dem Minuend-Eingang des zweiten Komparators c2 über den sechsten Inverter i6 zugeführt. Die jeweils beiden anderen Eingänge sind mit dem Stellsignal si gespeist. Der erste bzw. zweite Komparator c1, c2 liefert eine logische Eins, wenn si gleich oder größer als +B bzw. gleich oder kleiner als -B ist.

Der Minuend-größer/gleich-Subtrahend-Ausgang des ersten Komparators c1 liegt am einen Eingang des ersten UND-Gatters g1, dessen anderer Eingang mit der Vorzeichenstelle des Fehlersignals fi gespeist ist, was bei Signalen in Zweierkomplement-Darstellung zu einer logischen Eins am Ausgang des Gatters g1 für fi größer/gleich null führt.

Der Subtrahend-kleiner/gleich-Minuend-Ausgang des zweiten Komparators c2 ist mit dem einen Eingang des zweiten UND-Gatters g2 verbunden, dessen invertierendem anderen Eingang die Vorzeichenstelle des Fehlersignals fi direkt zugeführt ist. Die Ausgänge der beiden UND-Gatter g1, g2 sind jeweils auf einen Eingang des ODER-Gatters o geführt, dessen dritter Eingang mit dem Blockiersignal b gespeist ist. Der Ausgang des ODER-Gatters o ist auf den Steuereingang des dritten elektronischen Umschalters sw3 geführt. Somit ist dieser auf den Eingang 1 mit der dort anliegenden "O" geschaltet, wenn wenigstens eines der drei Eingangssignale des ODER-Gatters o logisch eins ist.

Der Ausgang des dritten elektronischen Umschalters sw3 ist der Ausgang der Steuereinrichtung st. Dieser liefert das Inkrement Q als positiven oder negativen Wert an den Eingang des zweiten Akkumulators ac2, um dessen Inhalt zu vergrößern oder zu verkleinern.

Der Wert des Inkrements Q ist dabei klein im Vergleich zu dem des Stellsignals si. Wie erwähnt, wird im Audiosignalbereich bei der digitalen Signalverarbeitung für die Signalpegel üblicherweise der Zahlenbereich von -1 bis +1 verwendet, wobei je nach der maximal möglichen Auflösung eine entsprechende Anzahl von Nachkommastellen erforderlich ist.

Umfaßt beispielsweise das Adreß-Wort I zwei Binärstellen, so können damit vier verschiedene Inkremente Q abgerufen werden, z.B. $Q = 2^{-13}, 2^{-14}, 2^{-15}, 2^{-16}$, die dem Akkumulator ac2 zugeführt werden. Das im Bereich +1 bis -1 aussteuerbare Stellsignal si wird durch das Begrenzungsbereich-Wort B auf einen engeren Wertebereich begrenzt, z.B. auf $-2^{-2}$ bis $+2^{-2}$.

| Funktionstabelle zur Bildung des Inkrements Q | | | |
|---|---|---|---|
| | si ≤ -B | -B < si < +B | si ≥ +B |
| fi < 0 b = 0 | Q > 0 | Q > 0 | Q = -0 |
| fi ≥ 0 b = 0 | Q = 0 | Q < 0 | Q < 0 |
| fi beliebig b = 1 | Q = 0 | Q = 0 | Q = 0 |

**Patentansprüche**

1. Korrekturschaltung für ein aus Inphase-Signal im folgenden u-Signal (u) genannt, und Quadratur-Signal, im folgenden v-Signal (v) genannt, bestehendes digitales Signalpaar (u, v; u', v')
   - mit einer Offset-Korrekturstufe (oc), die mit einem Inphase-Offset-Stellsignal, im folgenden u-Stellsignal (su) genannt, und mit einem Quadratur-Offset-Stellsignal, im folgenden v-Stellsignal (sv) genannt, gespeist ist,

- mit einer Phasen- und mit einer Amplituden-Korrekturstufe (pc bzw. gc), der ein Phasen- bzw. ein Amplituden-Stellsignal (sp bzw. sg) zugeführt ist, und
- mit einer Werte-Erfassungsstufe (ws), die mit dem digitalen Signalpaar (u, v; u', v') gekoppelt ist,

gekennzeichnet durch folgende Merkmale:

- in der Werte-Erfassungsstufe (ws) ist
-- das dem Inphase-Signalpfad (U) entstammende u-Signal (u) einem ersten Minimum-Detektor (n1) zur Bildung eines Inphase-Minimalwertes, im folgenden u-Minwert (un) genannt, und einem ersten Maximum-Detektor (m1) zur Bildung eines Inphase-Maximalwertes, im folgenden u-Maxwert (um) genannt, zugeführt und
-- das dem Quadratur-Signalpfad (V) entstammende v-Signal (v) einem zweiten Minimum-Detektor (n2) zur Bildung eines Quadratur-Minimalwertes, im folgenden v-Minwert (vn) genannt, einem zweiten Maximum-Detektor (m2) zur Bildung eines Quadratur-Maximalwertes, im folgenden v-Maxwert (vm) genannt, einer ersten und einer zweiten Halteschaltung (h1, h2) zugeführt, die dann einen ersten bzw. einen zweiten Quadratur-Haltewert, im folgenden v-Haltewert (vh1 bzw. vh2) genannt, abspeichert, wenn der u-Minwert bzw. der u-Maxwert auftritt,
- in einer Fehler-Erkennungsstufe (fs) ist
-- mittels eines ersten Addierers (a1) aus dem u-Maxwert (um) und dem u-Minwert (un) ein Inphase-Offsetfehler-Signal, im folgenden u-Offsetsignal (uf) genannt, erzeugt,
-- mittels eines zweiten Addierers (a2) aus dem v-Maxwert (vm) und dem v-Minwert (vn) ein Quadratur-Offsetfehler-Signal, im folgenden v-Offsetsignal) (vf) genannt, erzeugt,
-- mittels eines ersten Subtrahierers (sb1) ein Phasenfehler-Signal (pf) erzeugt, wobei als Minuend der zweite v-Haltewert (vh2) und als Subtrahend der erste v-Haltewert (vh1) dient,
-- mittels eines zweiten Subtrahierers (sb2) ein Inphase-Amplitudenwert, im folgenden u-Amplitude (ua) genannt, erzeugt, wobei als Minuend der u-Maxwert (um) und als Subtrahend der u-Minwert (un) dient,
-- mittels eines dritten Subtrahierers (sb3) ein Quadratur-Amplitudenwert, im folgenden v-Amplitude (va) genannt, erzeugt, wobei als Minuend der v-Maxwert (vm) und als Subtrahend der v-Minwert (vn) dient, und
-- mittels eines vierten Subtrahierers (sb4) als Amplitudenvergleichsstufe ein Amplitudenfehler-Signal (af) erzeugt, dessen Minuend-Eingang mit der v-Amplitude (va) und dessen Subtrahend-Eingang mit der u-Amplitude (ua) gespeist ist, und
- ein erster bzw. zweiter bzw. dritter bzw. vierter Regler (r1, r2, r3, r4) ist an seinem jeweiligen Eingang mit dem u-Offsetsignal (uf) bzw. mit dem v-Offsetsignal (vf) bzw. mit dem Phasenfehler-Signal (pf) bzw. mit dem Amplitudenfehler-Signal (af) gespeist und liefert an seinem jeweiligen Ausgang das u-Stellsignal (su) bzw. das v-Stellsignal (sv) bzw. das Phasen-Stellsignal (sp) bzw. das Amplituden-Stellsignal (sg).

2. Korrekturschaltung nach Anspruch 1, wobei der erste bzw. der zweite Minimumdetektor (n1, n2) einen dritten bzw. einen vierten Maximum-Detektor (m3, m4) enthält, deren jeweiliger Signaleingang das u- bzw. das v-Signal (u, v) über einen ersten bzw. einen zweiten Inverter (i1, i2) zugeführt ist und deren Ausgangssignal über einen dritten bzw. einen vierten Inverter (i3, i4) geführt ist.

3. Korrekturschaltung nach Anspruch 2, wobei mindestens einer der Maximumdetektoren (m1... m4) folgende Schaltungsteile aufweist:

- einen mittels eines ersten Reset-Signals (rs1) löschbaren Maximum-Speicher zur Speicherung eines Maximalwertes (sm),
- eine Einrichtung zur Abgabe eines Detektorsignals (di), wenn der Maximalwert (sm) zunimmt,
- eine Nachlaufstufe (ns), die
-- einen fünften und einen sechsten Subtrahierer (sb5, sb6) enthält, deren jeweilige Subtrahend-Eingänge gemeinsam mit dem Maximalwert (sm) gespeist sind und deren jeweiligem Minuend-Eingang ein Eingangssignal (se) bzw. ein fester Vorgabewert (sl) zugeführt ist,
-- einen ersten bzw. einen zweiten Festwertmultiplizierer (ma, md) enthält, der mit dem Ausgang des fünften bzw. des sechsten Subtrahieres (sb5, sb6) verbunden ist, und
-- einen ersten elektronischen Umschalter (sw1) enthält, dessen erster bzw. zweiter Eingang (1, 2) am Ausgang des ersten zweiten bzw. Festwertmultiplizierers (md, ma) liegt und vom Ausgang des fünften Subtrahierers (sb5) in die erste bzw. zweite Schaltposition (1, 2) gesteuert ist, wenn das Ausgangssignal des fünften Subtrahierers (sb5), dessen Vorzeichenstelle als Detektorsignal (di) dient, kleiner bzw. größer/gleich null ist.

**4.** Korrekturschaltung nach Anspruch 3 mit einem ersten Akkumulator (ac1) als Maximum-Speicher, der einen ersten Verzögerer (z1) und einen dritten Addierer (a3) enthält, dessen einer Eingang am Ausgang des ersten elektronischen Umschalters (sw1) und dessen anderer Eingang am Ausgang des ersten Verzögerers (z1) liegt,
- dessen Eingang mit dem Ausgang des dritten Addierers (a3) verbunden ist,
- der mittels eines ersten Reset-Signals (rs1) löschbar ist und
- an dessen Ausganng der Maximalwert (sm) abzugreifen ist.

**5.** Korrekturschaltung nach Anspruch 1, wobei die Offset-Korrekturstufe (oc) eine erste und eine zweite Addierschaltung (ad1, ad2) enthält, deren jeweiliger erster Eingang vom unkorrigierten u- bzw. vom unkorrigierten v-Signal (u′, v′) und deren jeweiliger zweiter Eingang vom u- bzw. vom v-Stellsignal (su, sv) gespeist sind, und wobei am Ausgang der ersten bzw. der zweiten Addierschaltung (ad1, ad2) ein offset-korrigiertes u- bzw. ein offset-korrigiertes v-Signal (uo, vo) abzugreifen ist.

**6.** Korrekturschaltung nach Anspruch 1, bei der die Phasen-Korrekturstufe (pc) eine dritte Addierschaltung (ad3) und einen ersten Multiplizierer (mp) enthält, wobei
- der erste bzw. der zweite Eingang der dritten Addierschaltung (ad3) mit dem, vorzugsweise offset-korrigierten, v-Signal bzw. dem Ausgangssignal der 1. Multiplizierers (mp) gespeist ist,
- der erste bzw. zweite Eingang des ersten Multiplizierers (mp) mit dem, vorzugsweise offset-korrigierten, u-Signal, das auch als phasenkorrigiertes u-Signal (up) dient bzw. mit dem Phasen-Shellsignal (sp), gespeist ist und
- das Ausgangssignal der dritten Addierschaltung (ad3) als phasenkorrigiertes v-Signal (vp) dient.

**7.** Korrekturschaltung nach Anspruch 1, bei der die Amplituden-Korrekturstufe (gc) eine vierte Addierschaltung (ad4) und einen zweiten Multiplizierer (mg) enthält, wobei
- der jeweilige erste Eingang der vierten Addierschaltung und des zweiten Multiplizierers mit dem, vorzugsweise offset- und phasenkorrigierten, v-Signal gespeist sind,
- der zweite Eingang der vierten Addierschaltung am Ausgang des zweiten Multiplizierers liegt, dessen zweiter Eingang mit dem Amplituden-Stellsignal (sg) gespeist ist,
- das Ausgangssignal der vierten Addierschaltung als amplituden-korrigiertes v-Signal (vg) dient und
- das in der Amplituden-Korrekturstufe (gc) durchverbundene, vorzugsweise offset- und phasenkorrigierte, u-Signal als amplituden-korrigiertes u-Signal (ug) dient.

**8.** Korrekturschaltung nach Anpruch 1, bei der mindestens einer der vier Regler (r1,...r4) folgende Teilschaltungen enthält:
- eine Steuereinrichtung (st), der als Eingangssignale ein Fehler-Signal (fi), ein Blockiersignal (b), ein Adreß-Wort (I), ein Begrenzungsbereich-Wort (B) und ein am Ausgang des jeweiligen Reglers abgegriffenes Stellsignal (si) zugeführt sind, und
- einen mittels eines zweiten Reset-Signals (rs2) löschbaren zweiten Akkumulator (ac2), dessen Dateneingang am Ausgang der Steuereinrichtung (st) liegt und dessen Inhalt das Stellsignal (si) darstellt.

**9.** Korrekturschaltung nach Anspruch 8, bei der die Steuereinrichtung (st) folgende Schaltungsteile enthält:
- einen durch das Adreß-Wort (I) auslesbaren Inkrement-Speicher (rr), der den jeweiligen Adresseninhalt dem ersten Eingang (1) eines zweiten elektronischen Umschalters (sw2) direkt bzw. dessen zweitem Eingang (2) über einen fünften Dateninverter (i5) zuführt und dessen jeweilige Position vom Vorzeichen des Fehler-Signals (fi) gesteuert ist,
- eine erste bzw. eine zweite Vergleichsschaltung (c1, c2), deren Subtrahend-Eingang bzw. deren Minuend-Eingang mit dem Begrenzungsbereich-Wort (B) direkt bzw. über einen sechsten Inverter (i6) und deren Minuend-bzw. Subtrahend-Eingang mit dem Stellsignal (si) gespeist ist,
- ein erstes UND-Gatter (g1), dessen einem Eingang das Fehlersignal (fi) und dessen anderem Eingang das Ausgangssignal der ersten Vergleichsschaltung (c1) zugeführt ist,
- ein zweites UND-Gatter (g2), dessen invertierendem einen Eingang das Fehlersignal (fi) und dessen nichtinvertierendem anderen Eingang das Ausgangssignal der zweiten Vergleichsschaltung (c2) zugeführt ist,
- ein ODER-Gatter (o), dessen Ausgangssignal einen dritten elektronischen Umschalter (sw3) steuert, dessen erster bzw. zweiter Eingang (1, 2) mit dem Datenwert "O" bzw. mit dem Ausgangssignal des zweiten elektronischen Umschalters (sw2) gespeist ist und dessen Ausgang mit dem Dateneingang des zweiten Akkumulators (ac2) verbunden ist, wobei die Eingangssignale des ODER-Gatters (o) das Blockier-Signal (b) und die Ausgangssignale des ersten und des zweiten UND-Gatters (g1, g2) sind.

10. Korrekturschaltung nach einem der Ansprüche 1 bis 9, wobei das digitale Signalpaar (u, v; u', v') einer Tief-Zwischenfrequenz-Umsetzungsschaltung mit einem ersten und einem zweiten Hochfrequenzmischer (hm1, hm2) sowie einem lokalen Oszillator (lo) entstammt, dessen Mischungsfrequenz im Nutzband des Hochfrequenz-Signals (hf) liegt, zur eigentlichen Trägerfrequenz jedoch einen vorbestimmten Frequenzabstand aufweist.

11. Verfahren zur Offset-, Phasen- und Amplitudenkorrektur eines aus einem Inphase-Signal (u) und einem Quadratur-Signal (v) bestehenden digitalen Signalpaars,
gekennzeichnet durch folgende Merkmale:
   - Minimalwerte (un, vn) und Maximalwerte (um, vm) des Inphase-Signals (u) und des Quadratur-Signals (v) werden mittels einer Werte-Erfassungsstufe (ws) bestimmt,
   - zeitgleich mit der Bestimmung des Minimal- und Maximalwertes (un bzw. um) des Inphase-Signals (u) werden mittels der Werte-Erfassungsstufe (ws) zugehörige Quadratur-Haltewerte (vh1 bzw. vh2) des Quadratur-Signals (v) bestimmt,
   - in einer Fehler-Erkennungsstufe (fs) werden aus den in der Werte-Erfassungsstufe (ws) bestimmten Werten (un, um, vn, vm, vh1, vh2) Fehlersignale (uf, vf, pf, af) gebildet und
   - die Fehlersignale werden jeweils mittels Reglern (r1, r2, r3, r4) in Stellsignale (su, sv, sp, sg) für das digitale Signalpaar (u, v) umgesetzt, wobei sich die jeweilige Regelrichtung daraus ergibt, daß die Absolutwerte der Minimal- und Maximalwerte (un, vn, um, vm) einander gleich werden sollen und daß die beiden Quadratur-Haltewerte (vh1, vh2) gegen Null gehen.

## Claims

1. A correction circuit for a digital signal pair (u, v; u', v') consisting of an in-phase signal, henceforth called "u-signal" (u), and a quadrature signal, henceforth called "v-signal" (v), comprising
   - an offset-correcting stage (oc) fed with an in-phase-offset-correcting signal, henceforth called "u-correcting signal" (su), and a quadrature-offset-correcting signal, henceforth called "v-correcting signal" (sv),
   - a phase-correcting stage (pc) and an amplitude-correcting stage (gc) fed with a phase-correcting signal (sp) and an amplitude-correcting signal (sg), respectively, and
   - a value-determining stage (ws) having the digital signal pair (n, v; u', v') coupled thereto,
   characterized by the following features:
   - In the value-determining stage (ws),
     -- the u-signal (u) from the in-phase-signal path (U) is fed to a first minimum detector (n1) for forming an in-phase minimum value, henceforth called "u-min value" (un), and to a first maximum detector (m1) for forming an in-phase maximum value, henceforth called "u-max value" (um), and
     -- the v-signal (v) from the quadrature-signal path (V) is fed to a second minimum detector (n2) for forming a quadrature minimum value, henceforth called "v-min value" (vn), to a second maximum detector (m2) for forming a quadrature maximum value, henceforth called "v-max value" (vm), and to a first hold circuit (h1) and a second hold circuit (h2) which store a first quadrature hold value and a second quadrature hold value, henceforth called "v-hold values" (vh1 and vh2, respectively), on the occurrence of the u-min and u-max values, respectively;
   - in an error-detecting stage (fs),
     -- an in-phase offset error signal, henceforth called "u-offset signal" (uf), is derived from the u-max value (um) and the u-min value (un) by means of a first adder (a1);
     -- a quadrature offset error signal, henceforth called "v-offset signal" (vf), is derived from the v-max value (vm) and the v-min value (vn) by means of a second adder (a2);
     -- a phase-error signal (pf) is derived by means of a first subtracter (sb1), with the second v-hold value (vh2) serving as a minuend and the first v-hold value (vh1) as a subtrahend;
     -- an in-phase amplitude value, henceforth called "u-amplitude" (ua), is derived by means of a second subtracter (sb2), with the u-max value (um) serving as a minuend and the u-min value (un) as a subtrahend;

-- a quadrature amplitude value, henceforth called "v-amplitude" (va), is derived by means of a third subtracter (sb3), with the v-max value (vm) serving as a minuend and the v-min value (vn) as a subtrahend, and

-- an amplitude-error signal (af) is derived by means of a fourth subtracter (sb4) used as an amplitude comparator whose minuend and subtrahend inputs are fed with the v-amplitude (va) and u-amplitude (ua), respectively, and

- a first controller (r1) is supplied at its input with the u-offset signal (uf), a second controller (r2) with the v-offset signal (vf), a third controller (r3) with the phase-error signal (pf), and a fourth controller (r4) with the amplitude-error signal (af), and the outputs of said controllers provide the u-correcting signal (su), the v-correcting signal (sv), the phase-correcting signal (sp), and the amplitude-correcting signal (sg), respectively.

2. A correction circuit as claimed in claim 1 wherein the first minimum detector (n1) contains a third maximum detector (m3) whose signal input is supplied with the u-signal (u) via a first inverter (i1) and whose output is passed through a third inverter (i3), and wherein the second minimum detector (n2) contains a fourth maximum detector (m4) whose signal input is supplied with the v-signal (v) via a second inverter (i2) and whose output is passed through a fourth inverter (i4).

3. A correction circuit as claimed in claim 2 wherein at least one of the maximum detectors (m1...m4) comprises the following subcircuits:
- a maximum memory for storing a maximum value (sm), said maximum memory being resettable by means of a first reset signal (rs1),
- a device for delivering a detector signal (di) when the maximum value (sm) increases, and
- a tracking stage (ns) containing
-- a fifth subtracter (sb5) and a sixth subtracter (sb6) whose respective subtrahend inputs are fed with the maximum value (sm) and whose respective minuend inputs are fed with an input signal (se) and a preset value (sl), respectively,
-- a first constant multiplier (ma) and a second constant multiplier (md) connected to the outputs of the fifth and sixth subtracters (sb5, sb6), respectively, and
-- a first electronic switch (sw1) whose first and second inputs (1, 2) are connected to the outputs of the second and first constant multipliers (md, ma), respectively, and which is caused by the output of the fifth subtracter (sb5) to assume its first position (1) when the output of the fifth subtracter (sb5), whose sign bit serves as the detector signal (di), is less than zero, and its second position (2) when the output of the fifth subtracter (sb5) is greater than or equal to zero.

4. A correction circuit as claimed in claim 3 wherein the maximum memory is a first accumulator (ac1) containing a first delay element (z1) and a third adder (a3) one input of which is connected to the output of the first electronic switch (sw1), and the other input of which is connected to the output of the first delay element (z1),
- whose signal input is connected to the output of the third adder (a3),
- which can be cleared by means of a first reset signal (rs1), and
- whose output provides the maximum value (sm).

5. A correction circuit as claimed in claim 1 wherein the offset-correcting stage (oc) contains a first adder (ad1) and a second adder (ad2) whose first inputs are supplied with the uncorrected u-signal (u') and uncorrected v-signal (v'), respectively, and whose second inputs are supplied with the u-correcting signal (su) and v-correcting signal (sv), respectively, with the outputs of the first and second adders (ad1, ad2) providing an offset-corrected u-signal (uo) and an offset-corrected v-signal (vo), respectively.

6. A correction circuit as claimed in claim 1 wherein the phase-correcting stage (pc) contains a third adder (ad3) and a first multiplier (mp),
- the first and second inputs of the third adder (ad3) being supplied with the, preferably offset-corrected, v-signal and the output signal from the first multiplier (mp), respectively,
- the first and second inputs of the first multiplier (mp) being supplied with the, preferably offset-corrected, u-signal, which also serves as a phase-corrected u-signal (up), and with the phase-correcting signal (sp), respectively, and
- the output of the third adder (ad3) serving as a phase-corrected v-signal (vp).

**7.** A correction circuit as claimed in claim 1 wherein the amplitude-correcting stage (gc) contains a fourth adder (ad4) and a second multiplier (mg),
- the first inputs of the fourth adder and the second multiplier being supplied with the, preferably offset- and phase-corrected, v-signal,
- the second input of the fourth adder being coupled to the output of the second multiplier, whose second input is supplied with the amplitude-correcting signal (sg),
- the output of the fourth adder serving as an amplitude-corrected v-signal (vg), and
- the, preferably offset- and phase-corrected, u-signal, which is transferred through the amplitude-correcting stage (gc) unchanged, serving as an amplitude-corrected u-signal (ug).

**8.** A correction circuit as claimed in claim 1 wherein at least one of the four controllers (r1...r4) contains the following subcircuits:
- a control facility (st) to which an error signal (fi), a blocking signal (b), an address word (I), a range-limit word (B), and a correcting signal (si) from the output of the controller are applied, and
- a second accumulator (ac2) which can be cleared by means of a second reset signal (rs2) and has its data input connected to the output of the control facility (st), and whose contents represent the correcting signal (si).

**9.** A correction circuit as claimed in claim 8 wherein the control facility (st) contains the following devices:
- an increment memory (rr) whose contents can be read by applying the address word (I) and which feeds the respective address contents to the first input (1) of a second electronic switch (sw2) direct and to the second input (2) of the second electronic switch (sw2) through a fifth data inverter (i5), the respective position of the second electronic switch (sw2) being determined by the sign of the error signal (fi),
- a first comparator (c1) whose subtrahend input is fed with the range-limit word (B) directly and whose minuend input is fed with the correcting signal (si), and a second comparator (c2) whose minuend input is fed with the range-limit word (B) via a sixth inverter (i6) and whose subtrahend input is fed with the correcting signal (si),
- a first AND gate (g1) whose two inputs are fed with the error signal (fi) and the output from the first comparator (c1), respectively,
- a second AND gate (g2) one input of which, which is an inverting input, is fed with the error signal (fi), and the other input of which, a noninverting input, is fed with the output from the second comparator (c2), and
- an OR gate (o) whose output controls a third electronic switch (sw3) whose first and second inputs (1, 2) are fed with the data value "O" and with the output signal from the second electronic switch (sw2), respectively, and whose output is connected to the data input of the second accumulator (ac2), the inputs to the OR gate (o) being the blocking signal (b) and the output signals from the first and second AND gates (g1, g2).

**10.** A correction circuit as claimed in any one of claims 1 to 9 wherein the digital signal pair (u, v; u', v') comes from a low-IF conversion circuit containing a first RF mixer (hm1), a second RF mixer (hm2), and a local oscillator (lo) whose frequency lies in the useful band of the RF signal (hf) but is separated from the carrier frequency by a predetermined distance.

**11.** A method for the offset, phase, and amplitude correction of a digital signal pair consisting of an in-phase signal (u) and a quadrature signal (v),
characterized by the following features:
- Minimum values (un, vn) and maximum values (um, vm) of the in-phase and quadrature signals (u, v) are determined by means of a value-determining stage (ws);
- simultaneously with the determination of the minimum and maximum values (un, um) of the in-phase signal (u), associated quadrature hold values (vh1, vh2) of the quadrature signal (v) are determined by means of the value-determining stage (ws);
- in an error-detecting stage (fs), error signals (uf, vf, pf, af) are formed from the values (un, um, vn, vm, vh1, vh2) determined in the value-determining stage (ws), and
- the error signals are converted to correcting signals (su, sv, sp, sg) for the digital signal pair (u, v) by means of respective controllers (r1, r2, r3, r4), with the respective direction of control following from the fact that the absolute values of the minimum and maximum values (un, vn, um, vm) are to become equal and that the two quadrature hold values (vh1, vh2) tend to zero.

14

EP 0 343 273 B1

**Revendications**

1. Circuit de correction pour un couple de signaux numériques (u,v; u',v'), constitué par un signal en phase désigné ci-après par signal u (u), et par un signal en quadrature, désigné ci-après par signal v (v),

   - comportant un circuit de correction d'offset (oc), qui est alimenté par un signal de réglage d'offset en phase, désigné ci-après par signal de réglage de u (su), et par un signal de réglage d'offset en quadrature, désigné ci-après par signal de réglage de v (sv),
   - un étage de correction de phase et un étage de correction d'amplitude (pc et gc), auxquels sont envoyés un signal de réglage de phase et un signal de réglage d'amplitude (sp et sg), et
   - un étage (ws) de détection de valeurs, qui est couplé au couple de signaux numériques (u,v; u',v'),

   caractérisé par les caractéristiques suivantes :

   - dans l'étage (ws) de détection de valeurs
     -- le signal u (u), qui arrive de la voie (U) de transmission du signal en phase, est envoyé à un premier détecteur de minimum (n1) pour la formation d'une valeur minimale en phase, désignée ci-après par valeur minimale de u (un), et un premier détecteur de maximum (m1) pour la formation d'une valeur maximale en phase, désignée ci-après par valeur maximale de u (um), et
     -- le signal v (v), arrivant de la voie (V) de transmission du signal en quadrature, est envoyé à un second détecteur de minimum (n2) pour la formation d'une valeur minimale en quadrature, désignée ci-après par valeur minimale de v (vn), à un second détecteur de maximum (m2) pour la formation d'une valeur maximale en quadrature, désignée ci-après par valeur maximale de v (vm), à des premier et second circuits de maintien (h1, h2), qui mémorisent des première et seconde valeurs de maintien en quadrature, désignées ci-après par valeur de maintien (vh1 ou vh2), lorsque la valeur minimale de u ou la valeur maximale de u apparaît,
   - dans un étage (fs) d'identification de défaut
     -- un signal de décalage d'offset en phase, désigné ci-après par signal d'offset de u (uf), est produit au moyen d'un premier additionneur (a1) à partir de la valeur maximale de u (um) et de la valeur minimale de u (un),
     -- un signal d'erreur d'offset en quadrature, désigné ci-après par signal d'offset de v (vf) est produit au moyen d'un second additionneur (a2) à partir de la valeur maximale de v (vm) et de la valeur minimale de V (un),
     -- un signal d'erreur de phase (pf) est produit au moyen d'un premier soustracteur (sb1), la seconde valeur de maintien de v (vh2) étant utilisée comme minuende et la première valeur de maintien v (vh1) étant utilisée comme nombre à soustraire,
     -- une valeur d'amplitude en phase, désignée ci-après par amplitude de u (ua) est formée au moyen d'un second soustracteur (sb2), la valeur maximale de u (um) étant utilisée comme minuende et la valeur minimale de u (un) comme nombre à soustraire,
     -- une valeur d'amplitude en quadrature, désignée ci-après par amplitude de v (va), est produite au moyen d'un troisième soustracteur (sb3), la valeur maximale de v (vm) étant utilisée comme minuende et la valeur minimale de v (vn) en tant que nombre à soustraire, et
     -- un signal d'erreur d'amplitude (af) est produit au moyen d'un quatrième soustracteur (sb4) utilisé comme étage comparateur d'amplitude, dont l'entrée du minuende reçoit l'amplitude de v (va) et dont l'entrée du nombre à soustraire reçoit l'amplitude de u (ua), et
   - des premier, second, troisième et quatrième régulateurs (r1, r2, r3, r4) reçoivent, au niveau de leurs entrées respectives, le signal d'offset de u (uf), le signal d'offset de v (vf), le signal d'erreur de phase (pf) et le signal d'erreur d'amplitude (af), et délivrent, sur leur sorties respectives, le signal de réglage de u (su), le signal de réglage de v (sv), le signal de réglage de phase (su) et le signal de réglage d'amplitude (sg).

2. Circuit de correction selon la revendication 1, dans lequel les premier et second détecteurs de minimum (n1, n2) contiennent respectivement des troisième et quatrième détecteurs de maximum ( m3, m4), dont les entrées respectives des signaux reçoivent le signal u et le signal v (u,v) par l'intermédiaire de premier et second inverseurs (i1, i2) et dont le signal de sortie est délivré par l'intermédiaire de troisième et quatrième inverseurs (i3,i4).

3. Circuit de correction selon la revendication 2, dans lequel au moins l'un des détecteurs de maximum (m1...m4) possède les éléments de circuit suivants :

15

- une mémoire de maximum effaçable au moyen d'un premier signal de remise à l'état initial (rsl) et servant à mémoriser une valeur maximale (sm),
- un dispositif pour délivrer un signal de détection (di), lorsque la valeur maximale (sm) augmente,
- un étage d'asservissement (ns), qui

-- contient des cinquième et sixième soustracteurs (sb5, sb6), dont les entrées respectives des nombres à soustraire sont alimentées en commun par la valeur maximale (sm) et dont les entrées respectives des minuendes reçoivent un signal d'entrée (se) et une valeur prédéterminée fixe (s), et

-- contient des premier et second multiplicateurs (ma, mb) réalisant une multiplication par des valeurs fixes et qui sont reliés aux sorties respectives des cinquième et sixième soustracteurs (sb5, sb6), et

-- contient un premier commutateur électronique (swl), dont la première ou la seconde entrée (1, 2) est raccordée à la sortie du second ou du premier multiplicateur (md, ma) réalisant une multiplication par une valeur fixe et est commutée par la sortie du cinquième soustracteur (sb5) dans la première ou la seconde position de commutation (1,2), lorsque le signal de sortie du cinquième soustracteur (sb5), dont la position de signe est utilisée comme signal de détection (di), est inférieur ou supérieur/égal à zéro.

4. Circuit de correction selon la revendication 3, comportant un premier accumulateur (ac1) en tant que mémoire de maximum, qui contient un premier circuit de retardement (z1) et un troisième additionneur (a3), dont une entrée est raccordée à la sortie du premier commutateur électronique (sw1) et dont l'autre entrée est raccordée à la sortie du premier circuit de retardement (z1),
   - dont l'entrée est raccordée à la sortie du troisième additionneur (a3), et
   - qui peut être effacée au moyen d'un signal de remise à l'état initial (rs), et
   - à la sortie de laquelle peut être prélevée la valeur maximale (sm).

5. Circuit de correction selon la revendication 1, dans lequel l'étage de correction d'offset (oc) contient des premier et second additionneurs (ad1, ad2), dont la première entrée respective reçoit le signal u non corrigé ou le signal v non corrigé (u',v') et dont la seconde entrée respective reçoit le signal de réglage de u ou le signal de réglage de v (su, sv), et dans lequel un signal u, dont l'offset est corrigé, ou un signal v, dont l'offset est corrigé, (uo, vo) peut être prélevé sur la sortie du premier ou du second circuit additionneur (ad1, ad2).

6. Circuit de correction selon la revendication 1, dans lequel l'étage de correction de phase (pc) contient un troisième circuit additionneur (ad3) et un premier multiplicateur (mp), et dans lequel
   - la première ou la seconde entrée du troisième circuit additionneur (ad3) reçoit le signal v, dont l'offset est de préférence corrigé, ou le signal de sortie du premier multiplicateur (mp),
   - la première ou la seconde entrée du premier multiplicateur (mp) reçoit le signal u, dont l'offset est de préférence corrigé et qui est également utilisé comme signal u dont la phase est corrigée (up), ou le signal de réglage de phase (sp), et
   - le signal de sortie du troisième circuit additionneur (ad3) est utilisé en tant que signal v, dont la phase est corrigée (vp).

7. Circuit de correction selon la revendication 1, dans lequel l'étage de correction d'amplitude (gc) contient un quatrième circuit additionneur (ad4) et un second multiplicateur (mg), et dans lequel
   - la première entrée respective du quatrième circuit additionneur et du second multiplicateur reçoit le signal v dont l'offset est de préférence corrigé et dont la phase est corrigée,
   - la seconde entrée du quatrième circuit additionneur est raccordée à la sortie du second multiplicateur, dont la seconde entrée reçoit le signal de réglage d'amplitude (sg),
   - le signal de sortie du quatrième circuit additionneur est utilisé en tant que signal v, dont l'amplitude est corrigée, (vg), et
   - le signal u, qui est transmis dans l'étage de correction d'amplitude (gc) et dont de préférence l'offset et la phase sont corrigés, est utilisé comme signal u dont l'amplitude est corrigée (ug).

8. Circuit de correction selon la revendication 1, dans lequel au moins l'un des quatre régulateurs (r1...r4) contient les circuits partiels suivants :
   - un dispositif de commande (st), auquel sont envoyés, en tant que signaux d'entrée, un signal d'erreur (fi), un signal de blocage (b), un mot d'adressage (I), un mot de zone limite (B) et un signal de réglage (si) prélevé à la sortie du régulateur respectif, et

- un second accumulateur (ac2), qui est effaçable au moyen d'un second signal de remise à l'état initial (rs2) et dont l'entrée des données est raccordée à la sortie du dispositif de commande (si) et dont le contenu représente le signal de réglage (st).

9. Circuit de correction selon la revendication 8, dans lequel le dispositif de commande (si) contient les éléments de circuit suivants :

- une mémoire d'incréments (rr), qui peut être lue au moyen du mot d'adressage (I) et qui envoie le contenu respectif d'adresse directement à la première entrée (1) d'un second commutateur électronique (sw2) et par l'intermédiaire d'un cinquième inverseur de données (i5) à la seconde entrée (2) de ce commutateur, et dont la position respective est commandée par le signe du signal d'erreur (fi),
- des premier et second circuits comparateurs (c1, c2), dont l'entrée du nombre à soustraire ou l'entrée du minuende est alimentée directement par l'intermédiaire d'un sixième inverseur (i6) et dont l'entrée du minuende et l'entrée du nombre à soustraire sont alimentées par le signal de réglage (si),
- une première porte ET (g1), à une entrée de laquelle est envoyé le signal d'erreur (fi), et à l'autre entrée de laquelle est envoyé le signal de sortie du premier circuit comparateur (c1),
- une seconde porte ET (g2), à l'entrée inverseuse de laquelle est envoyé le signal d'erreur (fi), et à l'autre entrée non inverseuse de laquelle est envoyé le signal de sortie du second circuit comparateur (c2),
- une porte OU (o), dont le signal de sortie commande un troisième commutateur électronique (sw3), dont les première et seconde entrées (1,2) sont alimentées respectivement par le mot de donnée "O" et par le signal de sortie du second commutateur électronique (sw2), et dont la sortie est raccordée à l'entrée de données du second accumulateur (ac2), les signaux d'entrée de la porte OU (o) représentant le signal de blocage (b) et les signaux de sortie des première et seconde portes ET (g1,g2).

10. Circuit de correction selon l'une des revendications 1 à 9, dans lequel le couple de signaux numériques (u, v; u', v') est délivré par un circuit de conversion à fréquence intermédiaire comportant un premier mélangeur à haute fréquence et un second mélangeur à haute fréquence (hm1, hm2) ainsi qu'un oscillateur local (lo), dont la fréquence de mélange se situe dans la bande utile du signal à haute fréquence (hf), mais présente un écart de fréquence prédéterminé par rapport à la fréquence porteuse proprement dite.

11. Procédé de correction d'offset, de phase et d'amplitude d'un couple de signaux numériques, constitué par un signal en phase (u) et un signal en quadrature (v),
caractérisé par les caractéristiques suivantes :

- des valeurs minimales (un, vn) et des valeurs maximales (um, vm) du signal en phase (u) et du signal en quadrature (v) sont déterminées au moyen d'un étage (ws) de détection de valeurs,
- en même temps que s'effectue la détermination de la valeur minimale et de la valeur maximale (un et um) du signal en phase (u), des valeurs de maintien en quadrature associées (vh1 et vh2) du signal en quadrature (v) sont déterminées au moyen de l'étage (ws) de détection de valeurs,
- dans étage d'identification d'erreur (fs), des signaux d'erreur (uf, vf, pf, af) sont formés à partir des valeurs (un, um, vn, vm, vh1, vh2), déterminées dans l'étage (ws) de détection de valeurs, et
- les signaux d'erreur sont convertis en des signaux de réglage (su, sv, sp, sg) pour le couple de signaux numériques (uv), respectivement au moyen de régulateurs (r1, r2, r3, r4), le dispositif respectif de régulation établissant à partir de là que les valeurs absolues des valeurs minimales et maximales (un, vn, um, vm) doivent être égales entre elles et que les deux valeurs de maintien en quadrature (vh1, vh2) tendent vers zéro.

FIG.1

FIG.2

FIG.3

# FIG.4

# FIG.5

# FIG.6

FIG.7

FIG.8